(19) **Europäisches Patentamt / European Patent Office / Office européen des brevets**

(11) **EP 4 147 062 B1**

(12) # FASCICULE DE BREVET EUROPEEN

(45) Date de publication et mention de la délivrance du brevet:
**05.06.2024  Bulletin 2024/23**

(21) Numéro de dépôt: **21806008.5**

(22) Date de dépôt: **13.10.2021**

(51) Classification Internationale des Brevets (IPC):
**G01R 33/24** *(2006.01)*   **G01R 33/565** *(2006.01)*
**G01R 33/56** *(2006.01)*

(52) Classification Coopérative des Brevets (CPC):
**G01R 33/5605; G01R 33/243; G01R 33/246;
G01R 33/56563; G01R 33/5659**

(86) Numéro de dépôt international:
**PCT/FR2021/051785**

(87) Numéro de publication internationale:
**WO 2022/090644 (05.05.2022 Gazette 2022/18)**

(54) **PROCÉDÉ DE POST-TRAITEMENT D'UN ÉCHANTILLONNAGE D'UNE SÉQUENCE D'ACQUISITION WASAB1**

VERFAHREN ZUR NACHBEARBEITUNG VON DATEN EINER WASAB1-AKQUISITIONSSEQUENZ

METHOD FOR CARRYING OUT POST-PROCESSING ON DATA FROM A WASAB1 ACQUISITION SEQUENCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **29.10.2020  FR 2011110**

(43) Date de publication de la demande:
**15.03.2023  Bulletin 2023/11**

(73) Titulaire: **Olea Medical**
**13600 La Ciotat (FR)**

(72) Inventeurs:
• **GY, Benoît**
  **13600 LA CIOTAT (FR)**
• **PAPAGEORGAKIS, Christos**
  **13600 LA CIOTAT (FR)**
• **CASAGRANDA, Stefano**
  **20060 BUSSERO (MILANO) (IT)**

• **BOUTELIER, Timothé**
  **CEYRESTE 13600 (FR)**

(74) Mandataire: **Med'inVent Consulting**
**Espace Mistral Bâtiment A**
**297, avenue du Mistral**
**13705 La Ciotat Cedex (FR)**

(56) Documents cités:
**EP-A1- 3 617 733**

• **SCHUENKE PWINDSCHUH JROELOFFS VLADD MEBACHERT PZAISS M.: "Simultaneous mapping of water shift and B 1 (WASAB1) application to field-inhomogeneity correction of CEST MRI data", MAGNETIC RESONANCE IN MEDICINE, février 2017 (2017-02), XP002803383, cité dans la demande**

**Description**

L'invention concerne un procédé de post-traitement d'une séquence d'acquisition WASAB1, telle que divulguée dans le document « Simultaneous mapping of water shift and B1 (WASAB1) - application to field-inhomogeneity correction of CEST MRI data. Magnetic résonance in medicine. 2017 Feb - Schuenke P, Windschuh J, Roelofifs V, Ladd ME, Bachert P, Zaiss M. », ci-après désigné par « Publication ». Une telle séquence WASAB1 permet de cartographier simultanément le champ magnétique statique B0 et le champ magnétique d'excitation B1 d'un appareil d'imagerie par résonance magnétique, plus connu sous le sigle IRM ou MRI, pour *Magnetic Résonance Imaging,* selon une terminologie anglo-saxonne. Un tel procédé de post-traitement trouve naturellement son application dans le cadre de l'imagerie CEST (Transfert de Saturation d'Échanges Chimiques ou *Chemical Exchange Saturation Transfer,* selon une terminologie anglo-saxonne), pour laquelle la séquence WASAB1 a été inventée mais, plus généralement, dans toute application d'imagerie par résonance magnétique pour laquelle une correction d'inhomogénéités desdits champs B0 et B1 est requise. L'application dudit procédé de post-traitement selon l'invention, lorsqu'il est appliqué à l'imagerie CEST, permet d'exploiter cette technique dans le domaine clinique et ainsi de quantifier un biomarqueur en lien avec une espèce chimique d'intérêt d'un organe humain ou animal pour, *in fine,* caractériser différentes lésions aux propriétés métaboliques altérées telles que des tumeurs, des tissus ischémiques ou une sclérose en plaques.

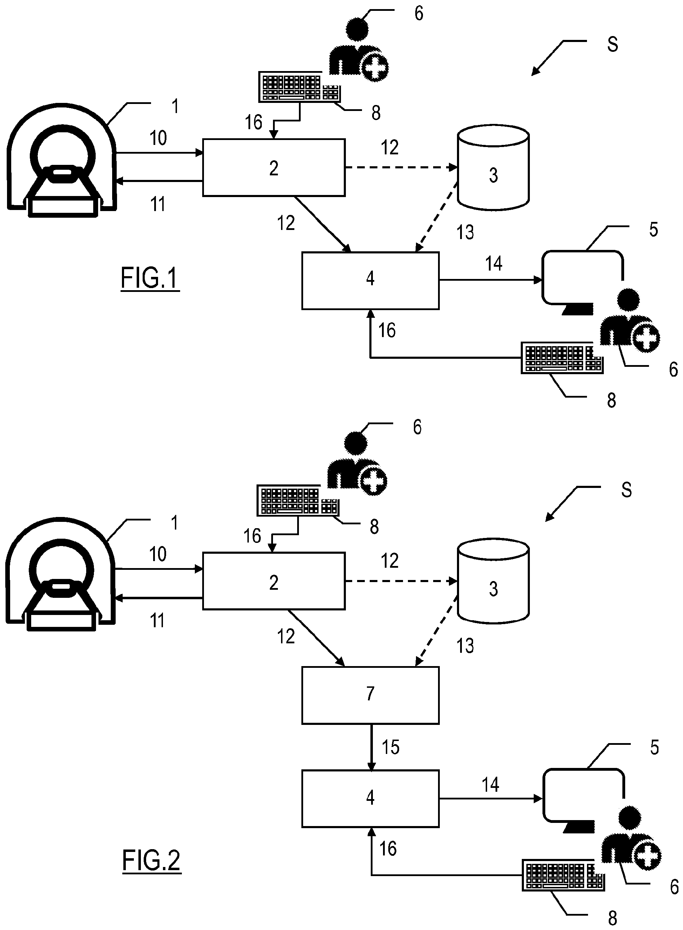

L'imagerie par résonance magnétique est basée sur une analyse de la réponse du proton d'une molécule d'eau lorsqu'il est excité dans un champ magnétique. Cette réponse dépend de l'environnement d'un tel proton et permet ainsi de différencier différents types de tissus. Un appareil d'imagerie 1 par Résonance Magnétique Nucléaire, tel qu'illustré à titre d'exemple non limitatif par les figures 1 et 2, est généralement utilisé. Celui-ci délivre une pluralité de séquences d'images numériques 12 d'une ou plusieurs parties du corps d'un patient, à titre d'exemples non limitatifs, le cerveau, le coeur, les poumons. Ledit appareil applique pour cela une combinaison d'ondes électromagnétiques à haute fréquence sur la partie du corps considérée et mesure le signal réémis par certains atomes, tels qu'à titre d'exemple non limitatif, l'hydrogène pour l'imagerie par Résonance Magnétique Nucléaire. L'appareil permet ainsi de déterminer les propriétés magnétiques et, par voie de conséquence, la composition chimique des tissus biologiques et donc leur nature, en chaque volume élémentaire, que l'on nomme communément un voxel, du volume imagé. L'appareil 1 d'imagerie par Résonance Magnétique Nucléaire est commandé à l'aide d'une console 2. Un utilisateur 6, par exemple un opérateur, praticien ou chercheur, peut ainsi choisir des commandes 11 pour piloter l'appareil 1, à partir de paramètres ou de consignes 16 saisis via une interface homme-machine d'entrée 8 du système d'analyse. Une telle interface homme-machine 8 peut consister par exemple en un clavier informatique, un dispositif de pointage, d'un écran tactile, un microphone ou, plus généralement, toute interface agencée pour traduire une gestuelle ou une consigne émise par un humain 6 en données de commande ou de paramétrage. A partir d'informations 10 produites par ledit appareil 1, on obtient une pluralité de séquences d'images numériques 12 d'une partie d'un corps d'un humain ou d'un animal. Nous nommerons également « données expérimentales » de telles informations 10 ou images 12.

Les séquences d'images 12 peuvent optionnellement être stockées au sein d'un serveur 3, c'est-à-dire un ordinateur doté de moyens de mémorisation propres et constituer un dossier médical 13 d'un patient. Un tel dossier 13 peut comprendre des images de différents types, telles que des images fonctionnelles mettant en évidence l'activité des tissus ou des images anatomiques reflétant les propriétés des tissus. Les séquences d'images 12 ou, plus généralement les données expérimentales, sont analysées par une unité de traitement 4 agencée à cette fin. Une telle unité de traitement 4 peut, par exemple, consister en un ou plusieurs microprocesseurs ou microcontrôleurs mettant en oeuvre des instructions de programmes d'application idoines chargées dans des moyens de mémorisation, tels qu'une mémoire non volatile, dudit système d'analyse d'imagerie. Ladite unité de traitement 4 comporte des moyens pour communiquer avec le monde extérieur pour recueillir les images. Lesdits moyens pour communiquer permettent en outre à l'unité de traitement 4 de délivrer, *in fine,* un rendu, par exemple graphique et/ou sonore, d'une estimation ou d'une quantification d'un biomarqueur élaborée par ladite unité de traitement 4 à partir des données expérimentales 10 et/ou 12 obtenues par Imagerie par Résonance Magnétique, à un utilisateur 6 du système d'analyse d'imagerie par l'intermédiaire d'une interface homme-machine de sortie 5. Dans tout le document, on entend par « interface homme-machine de sortie », tout dispositif, employé seul ou en combinaison, permettant de sortir ou de délivrer une représentation graphique, haptique, sonore ou, plus généralement, perceptible par l'humain, d'un signal physiologique reconstruit, en l'espèce un biomarqueur, à un utilisateur 6 d'un système d'analyse d'imagerie par Résonance Magnétique. Une telle interface homme-machine de sortie 5 peut consister de manière non exhaustive en un ou plusieurs écrans, haut-parleurs ou autres moyens alternatifs adaptés. Ledit utilisateur 6 du système d'analyse peut ainsi confirmer ou infirmer un diagnostic, décider d'une action thérapeutique qu'il jugera adéquate, approfondir des travaux de recherche, peaufiner des paramètres de réglage d'un équipement de mesure, etc. Optionnellement, cet utilisateur 6 peut également paramétrer le fonctionnement de l'unité de traitement 4 ou de l'interface homme-machine de sortie 5, au moyen de paramètres 16 de fonctionnement et/ou d'acquisition. Par exemple, il peut ainsi définir des seuils d'affichage ou choisir les biomarqueurs, indicateurs ou paramètres estimés ou quantifiés pour lesquels il souhaite disposer d'une représentation. L'utilisateur exploite pour cela l'interface homme-machine d'entrée 8 précédemment évoquée ou une deuxième interface d'entrée prévue pour cela. Avantageusement, les interfaces homme-machine d'entrée 8 et de sortie 5 peuvent ne constituer qu'une seule et même entité physique. Lesdites interfaces homme-machine d'entrée 8 et de sortie 5 du système d'analyse d'imagerie peuvent également être intégrées à la console d'acquisition 2. Il existe une variante, décrite en liaison avec la figure 2, pour laquelle un système d'imagerie, tel que décrit précédemment, comporte en outre une unité de prétraitement 7 pour analyser les séquences d'images 12, en déduire des signaux expérimentaux 15 et délivrer ces derniers à l'unité de traitement 4 qui est ainsi déchargée de cette tâche.

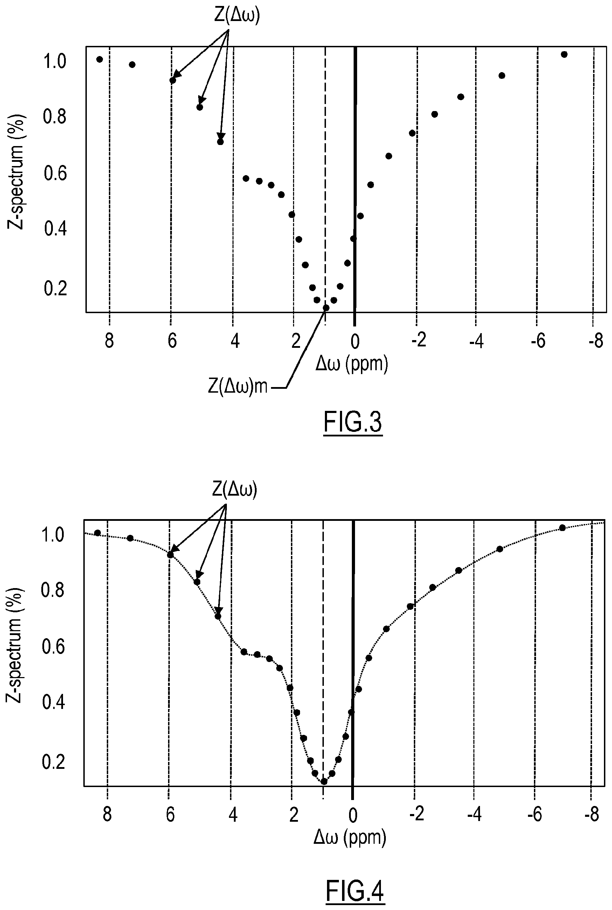

Parmi les techniques ou modalités basées sur l'imagerie par résonance magnétique, on distingue l'imagerie par Transfert de Saturation d'Echanges Chimiques ou CEST. Une telle technique consiste à appliquer une impulsion radiofréquence selon différentes fréquences de résonance déterminées $\omega$, de sorte que des espèces chimiques d'intérêt atteignent un état de saturation. Lesdites fréquences de résonance déterminées $\omega$ sont en effet respectivement associées à différentes espèces chimiques d'intérêt, telles que, de manière non limitative, le groupe amide (-NH), le groupe amine (-NH2) ou le groupe hydroxyle (-OH). Leurs protons d'hydrogènes labiles ainsi excités sont échangés avec des protons d'hydrogène non excités de l'eau. Une telle application d'une impulsion radiofréquence, à une fréquence de résonance déterminées $\omega$ autre que celle $\omega 0$ associée à l'eau, continuellement répétée pendant une durée déterminée, par exemple quelques secondes, conduit à une accumulation de saturation en eau d'une espèce chimique d'intérêt. Une concentration de cette dernière peut être indirectement mesurée par la diminution du signal de l'eau, phénomène appelé l'« effet CEST » qui est analysé sous la forme d'un spectre Z (« Z-spectrum » selon une terminologie anglo-saxonne). Une telle diminution peut être facilement détectée par des séquences d'acquisition d'imagerie par résonance magnétique rapides telles que l'imagerie écho-planaire à coup unique également connue sous la terminologie anglo-saxonne « single shot echo-planar imaging ». La figure 3 présente un exemple d'un spectre Z sous la forme d'un ensemble d'échantillons $Z(\Delta\omega)$ (ou « data set » selon une terminologie anglo-saxonne) selon des décalages fréquentiels relatifs $\Delta\omega$ par rapport à la fréquence de l'eau, de tels décalages $\Delta\omega$ étant exprimés en ppm. Lorsque les échantillons $Z(\Delta\omega)$ sont ordonnés selon des $\Delta\omega$ décroissants, comme l'indique la figure 3, ledit spectre Z peut être décrit sous la forme d'un signal discret décrivant des mesures, avantageusement normalisées par un signal mesuré sans saturation par radiofréquence et exprimées en pourcentages, de la magnitude d'un signal expérimental délivré par un appareil de mesure 1 pour un volume élémentaire d'un organe. Selon la figure 3, cet ensemble d'échantillons, lorsque ces derniers sont ordonnés selon des décalages fréquentiels $\Delta\omega$ décroissants, constitue un signal discret Z décrivant sensiblement un 'V' dont le minimum $Z(\Delta\omega)m$ est associé au décalage fréquentiel $\Delta\omega=1$ ppm. En toute logique, ledit minimum $Z(\Delta\omega)m$ devrait être associé à un décalage fréquentiel $\Delta\omega$ nul si ledit appareil était parfaitement réglé et/ou le champ magnétique statique était homogène.

La technique CEST améliore la détection de certains métabolites du corps humain dont la concentration est insuffisante pour être détectée par des séquences d'imagerie par résonance magnétique traditionnelles. Cette technique CEST permet ainsi d'obtenir des informations précieuses pour un praticien cherchant à établir un diagnostic et à prendre une décision thérapeutique dans le traitement de pathologies. Dans le domaine clinique, de tels biomarqueurs doivent cependant être produits de manière rapide et précise. La mise en oeuvre de la technique CEST nécessite toutefois selon l'état de la technique une puissance et/ou des temps de calculs incompatibles avec les exigences imposées par le domaine clinique notamment.

De nombreux effets interagissent avec le transfert de saturation durant une application continue d'impulsions radiofréquences, tels que la saturation directe en eau (DS pour « Direct water Saturation » selon une terminologie anglo-saxonne) ou encore le contraste de transfert d'aimantation (MT pour « Magnetization Transfer » selon une terminologie anglo-saxonne). D'autres phénomènes se combinent auxdits effets et sont inhérents à la mise en oeuvre d'une technique d'imagerie par résonance magnétique, tels que des inhomogénéités de champs magnétiques. En effet, le contraste CEST est basé sur l'échange chimique entre les protons labiles et l'eau. Le contraste MT provient quant à lui de l'échange de magnétisation entre les protons de l'eau et les protons dans un environnement solide ou semi-solide. Des corrections sont donc nécessaires pour un obtenir un signal CEST fiable. Par ailleurs, bien qu'en théorie, pour extraire un signal caractérisant la concentration d'une molécule d'intérêt, une saturation en eau ne nécessite que quelques localisations spectrales, par exemple, principalement autour de la fréquence de résonance de l'eau, en pratique une telle extraction est complexe en raison de la présence d'inhomogénéités du champ magnétique statique B0 des appareils d'imagerie par résonance magnétique. Ces inhomogénéités sont partiellement causées par les propriétés tissulaires du patient et entraînent un décalage des échantillons spectraux acquis, comme l'indique la figure 3.

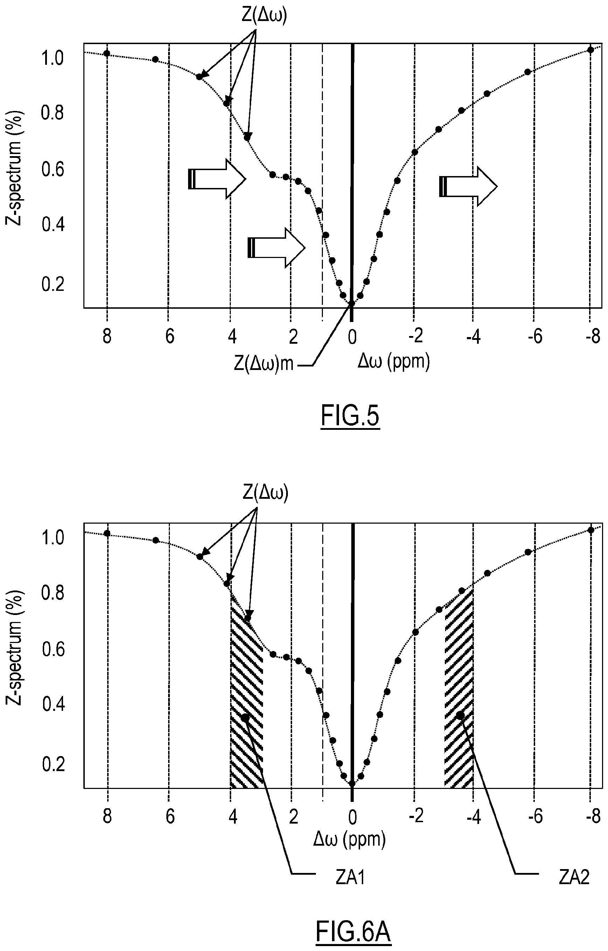

Pour surmonter ce problème, un échantillonnage dense est effectué autour de la fréquence de résonance de l'eau. Les mesures acquises sont ensuite normalisées par un signal mesuré sans saturation par radiofréquence. Avec une interpolation mathématique appropriée comme l'indique la figure 4, le spectre Z peut être obtenu, voxel par voxel, pour une plage de décalages fréquentiels d'intérêt. Les échantillons de ce dernier, après ordonnancement selon des décalages fréquentiels $\Delta\omega$ décroissants, décrivent un signal discret de forme ou courbe sensiblement en « V ». Ledit spectre Z est alors « recentré » pour que son minimum $Z(\Delta\omega)m$ corresponde à la fréquence de l'eau comme l'indique la figure 5. Le spectre Z peut ainsi être décrit sous une forme relative, la fréquence de l'eau étant égale à un décalage fréquentiel $\Delta\omega$ nul, les fréquences $\omega$ étant exprimées en ppm sous la forme d'un décalage fréquentiel relatif $\Delta\omega$, positif

ou négatif au regard de la fréquence de l'eau. Un tel décalage fréquentiel relatif est généralement exprimé en ppm. Une correction du paramètre B0, telle que l'illustre la figure 5, peut ainsi être appliquée pour une pluralité de voxels ou volumes élémentaires. Des cartes appelées cartes MBO intrinsèques, c'est-à-dire des images matricielles, peuvent être calculées puis affichées, en utilisant la position de décalage du minimum $Z(\Delta\omega)m$ du spectre Z pour un ensemble de volumes élémentaires.

La figure 6A illustre la détermination d'un premier exemple non limitatif d'un biomarqueur produit à partir d'un spectre Z tel que décrit précédemment en lien avec les figures 3 à 5. Un tel biomarqueur peut correspondre à la différence entre une première aire ZA1, que l'on nomme généralement « Label » selon une terminologie anglo-saxonne, sous la courbe interpolée du spectre Z à partir des échantillons $Z(\Delta\omega)$ et une deuxième aire ZA2, que l'on nomme généralement « Référence » selon une terminologie anglo-saxonne, sous ladite courbe, pour des plages de décalages fréquentiels $\Delta\omega$ respectives et symétriques au regard du décalage fréquentiel nul. En l'espèce, sur l'exemple de la figure 6A, l'aire ZA1 est associée aux décalages fréquentiels compris entre +3 ppm et +4 ppm et l'aire ZA2 est associée aux décalages fréquentiels compris entre -3 ppm et -4 ppm. Un tel choix de plages est usuellement associé aux amides. En effet, la fréquence de résonnance des amides correspond généralement en moyenne au décalage fréquentiel $\Delta\omega=3,5$ ppm. En variante, si l'on s'intéresse aux amines dont la fréquence de résonnance correspond généralement en moyenne au décalage fréquentiel $\Delta\omega=2$ ppm, lesdites plages pourront être choisies comme étant comprises respectivement de 1,5 ppm à 2,5 ppm pour l'aire ZA1 et de -1,5 ppm à -2,5 ppm pour l'aire ZA2. Des cartes paramétriques associées à ce biomarqueur peuvent être constituées et affichées éventuellement pour décrire ledit biomarqueur pour une pluralité de volumes élémentaires d'intérêt.

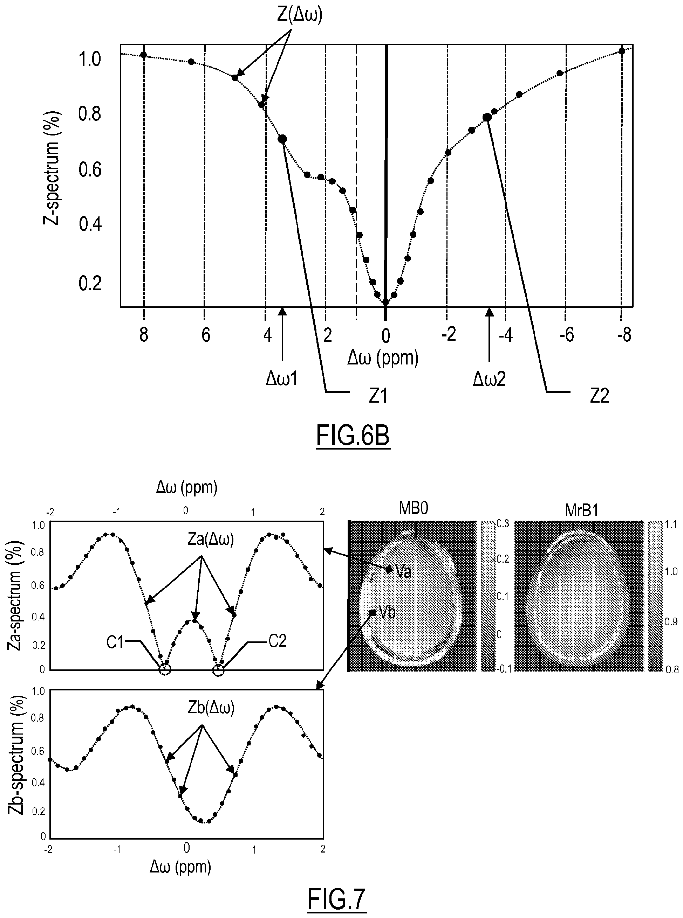

La figure 6B illustre la détermination d'un deuxième exemple non limitatif d'un biomarqueur produit à partir d'un spectre Z tel que décrit précédemment en lien avec les figures 3 à 5. Contrairement à l'exemple précédent selon lequel le biomarqueur est obtenu par soustraction de deux aires ZA1 et ZA2, ledit biomarqueur peut être produit par soustraction de deux valeurs interpolées d'échantillons Z1 et Z2 du spectre Z, lesdits échantillons étant également choisis de sorte que les décalages fréquentiels $\Delta\omega1$ et $\Delta\omega2$ qui leurs sont respectivement associés soient symétriques au regard du décalage fréquentiel $\Delta\omega=0$. A l'instar de l'exemple précédent, si l'on s'intéresse aux amides, comme l'indique la figure 6B, les décalages fréquentiels $\Delta\omega1=3,5$ppm et $\Delta\omega2=-3,5$ppm seront privilégiés. En variante ou en complément, si l'on s'intéresse aux amides, on pourra choisir des décalages fréquentiels $\Delta\omega1=2$ppm et $\Delta\omega2=-2$ppm. Un tel biomarqueur est nommé « Magnetic Transfer Ratio asymmetry (MTRasym) » selon une terminologie anglo-saxonne. De tels choix peuvent faire l'objet de paramétrages prédéterminés ou d'options renseignées par un utilisateur au moyen d'une interface homme-machine d'entrée appropriée.

L'augmentation de la densité des échantillons du spectre Z conduit à une résolution plus élevée des cartes MBO calculées mais l'acquisition de plusieurs échantillonnages du spectre Z induit un temps de calcul important et n'est pas toujours synonyme de résultats de cartographie du paramètre B0 optimaux.

Outre les difficultés induites par les inhomogénéités du champ magnétique statique B0 des appareils d'imagerie par résonance magnétique, un spectre Z est également affecté par les inhomogénéités du champ d'excitation B1. Pour surmonter ce problème, une correction du paramètre B1 est également généralement mise en oeuvre pour parvenir à extraire un signal CEST fiable.

Pour pallier ces inconvénients, la séquence WASAB1 a été proposée pour permettre une détermination plus précise de la fréquence de résonance des protons d'eau « en vrac ». Comme évoqué précédemment, les inhomogénéités du champ magnétique statique B0 et/ou du champ d'excitation B1 sont inévitables en imagerie par résonance magnétique. Elles provoquent des distorsions dans l'intensité des images acquises. Il est donc nécessaire de mettre en oeuvre un procédé de post-traitement d'une séquence WASAB1 pour augmenter la pertinence desdites intensités en déterminer précisément des informations spatiales en lien avec de la distribution des champs magnétiques B0 et B1 des appareils d'imagerie par résonance magnétique.

L'acquisition WASAB1 est une séquence d'acquisition en imagerie par résonance magnétique qui permet de cartographier simultanément le champ magnétique statique B0 et le champ d'excitation B1 sur la base d'oscillations de Rabi induites par une irradiation hors résonance qui peut être utilisée pour corriger les inhomogénéités précédemment évoquées.

Un spectre Z, résultant d'une séquence WASAB1, découle d'un échantillonnage selon plusieurs décalages fréquentiels (offsets selon une terminologie anglo-saxonne) autour de la fréquence de résonance de l'eau. Celui-ci est ensuite normalisé en utilisant une image M0 acquise pour des fréquences éloignées de la fréquence de l'eau. Les intensités du spectre $Z(\Delta\omega)$ WASAB1 d'un seul voxel peuvent être modélisées sur la base des équations de Bloch comme, par exemple et de manière non limitative comme le suggère la Publication :

$$Z(\Delta\omega) = \left| c - d \cdot \sin^2\left( \tan^{-1}\left( \frac{\gamma \cdot B1}{(\Delta\omega - B0)} \right) \right) \right.$$

$$\left. \cdot \sin^2\left( \sqrt{(\gamma \cdot B1)^2 + (\Delta\omega - B0)^2} \cdot \frac{tp}{2} \right) \right|$$

où $\Delta\omega$ sont les décalages fréquentiels relatifs autour de la fréquence de l'eau, c, d, B1 et B0 sont quatre paramètres libres. Les paramètres c et d décrivent la modulation d'amplitude indépendamment de tout décalage fréquentiel. Le paramètre B1 change la périodicité et B0 l'axe de symétrie de la fonction, $\gamma$ est le rapport gyromagnétique et tp est la durée de l'impulsion.

La fonction ou modèle précédent peut être écrit sous une forme simplifiée telle que :

$$Z(\Delta\omega) = \left| c - d \cdot f(B0, B1, \Delta\omega) \right|.$$

Comme l'indique la figure 7, en ajustant ces paramètres pour chaque volume élémentaire d'intérêt ayant fait l'objet d'une séquence WASAB1, tels que les volumes élémentaires Va et Vb référencés à titre d'exemples sur la figure 7, des cartes d'inhomogénéité MB0 et MrB1 peuvent être produites pour être utilisées à des fins de contrôle qualité pour corriger la séquence d'imagerie acquise. La carte MrB1 est obtenue en divisant la carte MB1 de WASAB1 par l'amplitude nominale du champ d'excitation. Généralement le champ magnétique d'excitation B1 nominal utilisé pour acquérir des séquences WASAB1 est de 3,7 $\mu$T. Malgré des temps d'acquisition rapides de séquences WASAB1, les temps de calcul pour mettre en oeuvre un post-traitement sont très lents car basés sur un ajustement d'un modèle à quatre paramètres c, d, B0 et B1 dérivés des équations de Bloch.

A l'heure actuelle, une seule méthode de post-traitement a été proposée dans la littérature pour déterminer les paramètres B0 et B1 d'une séquence WASAB1, à savoir la méthode exposée dans la Publication.

Une telle méthode consiste à minimiser la somme quadratique des erreurs résiduelles entre mesures et modèle à l'aide d'un procédé d'optimisation non linéaire. Un tel post-traitement connu comprend deux étapes.

Selon une première étape, l'espace des paramètres c, d, B0 et B1 est recherché de manière exhaustive au moyen d'une table ou grille de consultation à quatre dimensions pour trouver les meilleurs paramètres c, d, B0 et B1, pour chaque voxel ou volume élémentaire d'intérêt. En effet, pour éviter les minima locaux pendant la mise en oeuvre de l'étape d'ajustement, compte-tenu de la non-linéarité du modèle du signal, les auteurs ont créé cette table ou grille de recherche avec des spectres Z WASAB1 pour toutes les combinaisons possibles des quatre paramètres d'ajustement avant d'appliquer l'algorithme d'ajustement en tant que tel. La meilleure combinaison desdits paramètres est celle qui produit la plus petite erreur quadratique moyenne (« Means Square Error » ou MSE selon une terminologie anglo-saxonne) entre le spectre Z WASAB1 acquis pour un voxel et un spectre simulé pour un ensemble donné de paramètres sélectionnés dans ladite table ou grille de consultation.

La deuxième étape d'un tel procédé de post-traitement selon l'état de l'art est une étape d'ajustement du modèle aux données selon laquelle la meilleure combinaison des paramètres c, d, B0 et B1 précédemment trouvée est utilisée comme condition initiale pour un procédé de minimisation bornée utilisant l'algorithme de Levenberg-Marquardt.

Les nombreuses itérations qui doivent être mises en oeuvre, voxel par voxel, cumulées à un temps de calcul élevé pour mettre en oeuvre l'ajustement du modèle aux données, conduisent à une durée de mise en oeuvre du procédé de post-traitement supérieure à une heure. Une telle durée est prohibitive pour une application dans le domaine clinique.

En outre, le modèle analytique qui décrit le signal expérimental résultant d'une séquence WASAB1 prédit que pour certains ensembles de paramètres, ledit signal - que l'on pourrait qualifier de « théorique » et dont on ne mesure et connait que la magnitude pour différents décalages fréquentiels constituant ainsi un signal expérimental non polarisé - peut devenir négatif. Comme l'indique la figure 7, un tel signal expérimental théorique peut décrire une polarité variée pour un premier volume élémentaire Va, contrairement à ce que traduit les mesures de la magnitude d'un tel signal expérimental théorique en lien avec un deuxième volume élémentaire Vb. Un appareil d'imagerie par résonance magnétique mesurant la magnitude du signal expérimental théorique, le signe ou polarité dudit signal expérimental théorique est donc « perdu » pendant l'acquisition. Le spectre Z étant un signal ou ensemble d'échantillons que l'on peut qualifier de « non polarisés ». Ainsi, comme l'indique le spectre Za, associé à un volume élémentaire Va, des échantillons entre des points de rebroussement C1 et C2 (« cusps » selon une terminologie anglo-saxonne) décrivent des magnitudes d'un signal expérimental théorique de polarité négative. La mesure réalisée par l'appareil applique donc un filtre en valeurs absolues sur ledit signal expérimental théorique pour constituer un signal expérimental non polarisé, d'où l'apparition desdits points de rebroussement C1 et C2 sur ce dernier. Par conséquent, le modèle fait intervenir une valeur absolue pour tenir compte de cet effet de mesure. L'utilisation d'une valeur absolue rend le modèle complexe à estimer, car il introduit des discontinuités (points de rebroussement) dans la fonction que l'on cherche à minimiser. De plus, cela compromet toute mise en oeuvre d'optimisations pertinentes qui seraient possibles si le signe dudit signal n'était pas « perdu ». La figure 7 illustre ainsi les échantillons de mesure de la magnitude de deux signaux expérimentaux théoriques WASAB1 respectivement associés à deux volumes élémentaires distincts Va et Vb. Le spectre Za, associé à un premier volume élémentaire Va, décrit la magnitude d'un signal expérimental théorique à la polarité changeante ou variée, c'est-à-dire tantôt positive, tantôt négative, contrairement au spectre Zb, associé à un deuxième volume d'intérêt Vb, qui décrit des mesures de la magnitude d'un signal expérimental théorique de polarité systématiquement positive. Le spectre Za présente ainsi deux minima, sous la forme des points de rebroussement C1 et C2, entre lesquels la magnitude du signal mesurée correspond à une amplitude négative du signal expérimental théorique associé au premier volume élémentaire Va, contrairement aux échantillons situés de part et d'autre desdits deux points de rebroussement C1 et C2 qui décrivent des magnitudes d'un signal expérimental théorique dont l'amplitude, pour les décalages fréquentiels considérés, est de polarité positive. La figure 7 présente en outre les cartes paramétriques MBO et MrB1 précédemment évoquées pour l'ensemble des volumes élémentaires d'une tranche d'un cerveau humain. Nous pouvons constater que le paramètre B0, décrit un champ magnétique statique inhomogène compris entre -0,1 ppm et +0,3 ppm.

L'invention permet de répondre à tout ou partie des inconvénients soulevés par les solutions connues ou précédemment mentionnées.

Parmi les nombreux avantages apportés par l'invention, nous pouvons mentionner que :

- un procédé de post-traitement des échantillons d'un signal expérimental, fruit d'une séquence WASAB1, est agencé pour produire estimation robuste et très rapide, au regard des temps et difficultés de mise en oeuvre selon l'état de l'art, des paramètres B0 et B1 décrivant respectivement le champ magnétique statistique et le champ magnétique d'excitation de l'appareil d'imagerie médicale réalisant la mesure échantillonnée d'un signal expérimental théorique ;
- la mise en oeuvre d'un tel procédé de post-traitement ouvre au domaine clinique notamment la technologie CEST particulièrement prometteuse pour délivrer une aide à la décision et au diagnostic en lien avec de nombreuses pathologies ;

- l'estimation desdits paramètres B0 et B1, selon l'invention, s'appuie sur l'exploitation d'un modèle plus simple puisqu'il ne comporte que deux paramètres au lieu de quatre et, également plus stable que celui décrit selon l'état de l'art, réduisant de manière significative les aberrations dans l'estimation desdits paramètres B0 et B1 et, par voie de conséquence, permettant la production de cartes paramétriques mises à la disposition du personnel médical, de grandes qualités et précises ;
- la mise en oeuvre d'un procédé de post-traitement selon l'invention trouve une application directe et performante dans toute application d'imagerie par résonance magnétique pour laquelle une correction d'inhomogénéités desdits champs B0 et B1 est requise.

Pour cela, l'invention concerne tout d'abord un procédé (100) de post-traitement d'un premier ensemble Z d'échantillons $Z(\Delta\omega)$ d'un signal expérimental, fruit d'une séquence d'acquisition WASAB1 par un appareil d'imagerie médicale par résonance magnétique, en lien avec un volume élémentaire d'un organe, les valeurs respectives des échantillons $Z(\Delta\omega)$ dudit premier ensemble Z décrivant la magnitude d'un signal expérimental théorique selon des décalages fréquentiels $\Delta\omega$ par rapport à la fréquence de résonance de l'eau, ledit procédé étant mis en oeuvre par une unité de traitement d'un système d'analyse d'imagerie.

Pour une mise en oeuvre particulièrement efficace et rapide d'un tel procédé et, *in fine,* produire des estimations précises et robustes, un tel procédé comporte :

- une étape pour détecter les échantillons $Z(\Delta\omega)$ du premier ensemble Z pour lesquels les polarités des valeurs du signal expérimental théorique sont considérées certaines et construire un deuxième ensemble Y d'échantillons $Y(\Delta\omega)$ tels que :

  ◦ $Y(\Delta\omega)=Z(\Delta\omega)$ si la polarité du signal expérimental théorique est considérée certaine et positive ;
  ◦ $Y(\Delta\omega)=-Z(\Delta\omega)$ si la polarité dudit signal expérimental théorique est considérée certaine et négative ;

- une étape pour ajuster un modèle déterminé au deuxième ensemble d'échantillons Y, les deux paramètres dudit modèle déterminé décrivant respectivement les champs magnétiques statique B0 et d'excitation B1 de l'appareil d'imagerie médicale par résonance magnétique et produire une première estimation desdits paramètres B0 et B1 dudit modèle.

Le cas échéant, pour améliorer la pertinence des estimations produites, un procédé selon l'invention peut comporter :

- une étape pour estimer la polarité des valeurs du signal expérimental théorique mesuré pour tout ou partie des échantillons $Z(\Delta\omega)$ à partir du modèle ainsi ajusté et enrichir le deuxième ensemble Y d'échantillons comprenant un ensemble d'échantillons $Y(\Delta\omega)$ tels que $Y(\Delta\omega)=Z(\Delta\omega)$ si la polarité du signal expérimental théorique est estimée positive et $Y(\Delta\omega)=-Z(\Delta\omega)$ si la polarité du signal expérimental théorique est estimée négative ;
- une étape pour ajuster le modèle déterminé au deuxième ensemble Y d'échantillons et produire une deuxième estimation desdits paramètres B0 et B1.

Selon un premier mode de réalisation, l'étape pour détecter les échantillons $Z(\Delta\omega)$ du premier ensemble Z, pour lesquels les polarités des valeurs du signal expérimental théorique dont la magnitude est mesurée sont certaines, peut comporter :

- une première sous-étape, pour tout échantillon $Z(\Delta\omega)$, depuis le plus grand décalage fréquentiel négatif en valeur absolue vers un tel décalage fréquentiel nul, pour extrapoler la valeur dudit échantillon à partir de la ou des valeurs d'un ou plusieurs échantillons respectivement associés à différents décalages fréquentiels ;
- une deuxième sous-étape, pour tout échantillon $Z(\Delta\omega)$, depuis le plus grand décalage fréquentiel vers un tel décalage fréquentiel nul, pour extrapoler la valeur dudit échantillon à partir de la ou des valeurs d'un ou plusieurs échantillons respectivement associés à différents décalages fréquentiels.

Selon ce premier mode de réalisation, la polarité du signal expérimental théorique pour un décalage fréquentiel $\Delta\omega$ peut être déterminée par le signe de valeur extrapolée $Z(\Delta\omega)'$ de l'échantillon $Z(\Delta\omega)$ pour ledit décalage fréquentiel. Ladite polarité du signal expérimental théorique pour un décalage fréquentiel donné $\Delta\omega$ est considérée certaine et positive tant qu'une valeur extrapolée $Z(\Delta\omega)'$ d'un échantillon $Z(\Delta\omega)$ demeure positive.

Selon ce premier mode de réalisation de l'étape pour détecter les échantillons $Z(\Delta\omega)$ du premier ensemble Z pour lesquels les polarités des valeurs du signal expérimental théorique dont la magnitude est mesurée sont certaines, l'extrapolation de la valeur d'un échantillon $Z(\Delta\omega)$ peut consister, pour les première et deuxième sous-étapes, en une évaluation préalable du plus grand écart entre les valeurs respectives de deux échantillons $Z(\Delta\omega)$ associés à des décalages fréquentiels successifs et en la soustraction dudit plus grand écart à la valeur de l'échantillon associé au décalage fréquentiel supérieur en valeur absolue à celui associé à l'échantillon $Z(\Delta\omega)$ dont la valeur est extrapolée.

En variante, l'invention prévoit un deuxième mode de réalisation de l'étape pour détecter les échantillons $Z(\Delta\omega)$ du premier ensemble Z pour lesquels les polarités des valeurs du signal expérimental théorique mesuré sont certaines. Selon ce deuxième mode, ladite étape peut comporter :

- une première sous-étape pour calculer la dérivée d'un premier signal discret résultant d'un ordonnancement des échantillons dudit premier ensemble Z selon des décalages fréquentiels croissants ;
- une deuxième sous-étape pour détecter toute discontinuité de la polarité de ladite dérivée.

La polarité de la mesure du signal expérimental théorique est considérée certaine pour l'ensemble des décalages fréquentiels $\Delta\omega$ considérés, ladite polarité étant inversée lors de toute discontinuité détectée de la polarité de ladite dérivée.

Quel que soit le mode de réalisation de l'étape pour détecter les échantillons $Z(\Delta\omega)$ du premier ensemble Z traduisant des mesures de la magnitude du signal expérimental théorique dont les polarités des valeurs dudit signal expérimental théorique sont certaines, les étapes nécessaires à l'estimation des paramètres B0 et B1 en lien avec un volume élémentaire de l'organe peuvent être itérées pour produire une pluralité d'estimations desdits paramètres B0 et B1 en lien respectivement avec une pluralité de volumes élémentaires dudit organe.

Dans ce cas, afin de délivrer une aide précieuse pour calibrer l'appareil d'imagerie ou pour diagnostiquer certaines pathologies humaines ou animales, un procédé conforme à l'invention peut comporter une étape pour produire une image sous la forme d'une carte paramétrique dont les pixels encodent respectivement les valeurs du paramètre B0 ou B1 estimé pour des volumes élémentaires d'intérêts.

L'invention prévoit alors qu'un tel procédé puisse comporter une étape pour provoquer un affichage de ladite image produite par une interface homme-machine de sortie du système d'analyse d'imagerie.

Selon un deuxième objet, l'invention concerne un système d'analyse d'imagerie comportant une unité de traitement, des moyens pour communiquer avec le monde extérieur et des moyens de mémorisation. Les moyens pour communiquer d'un tel système sont agencés pour recevoir dudit monde extérieur des données expérimentales résultant d'une séquence d'acquisition WASAB1 de données réalisées par échantillonnage spectral d'un volume élémentaire d'un organe et les moyens de mémorisation comportent des instructions de programme dont l'interprétation ou l'exécution par ladite unité de traitement provoque la mise en oeuvre d'un procédé de post-traitement d'un premier ensemble Z d'échantillons $Z(\Delta\omega)$ d'un signal expérimental fruit d'une séquence d'acquisition WASAB1 conforme à l'invention.

Selon un troisième objet, l'invention concerne un produit programme d'ordinateur comportant une ou plusieurs instructions de programme interprétables par l'unité de traitement d'un système d'analyse d'imagerie, ledit programme étant chargeable dans des moyens de mémorisation dudit système, caractérisé en ce que l'interprétation desdites instructions par ladite unité de traitement provoque la mise en oeuvre d'un procédé de post-traitement d'un premier ensemble Z d'échantillons $Z(\Delta\omega)$ d'un signal expérimental théorique continu fruit d'une séquence d'acquisition WASAB1 conforme à l'invention.

Selon un quatrième objet, l'invention concerne un support de mémorisation lisible par un ordinateur comportant les instructions de programme d'un tel produit programme d'ordinateur.

D'autres caractéristiques et avantages apparaîtront plus clairement à la lecture de la description qui suit et à l'examen des figures qui l'accompagnent parmi lesquelles :

- la figure 1, d'ores-et-déjà décrite, illustre une description simplifiée d'un système d'analyse d'images obtenues par Résonance Magnétique Nucléaire ;
- la figure 2, d'ores-et déjà-décrite, illustre une description simplifiée d'une variante d'un système d'analyse d'images obtenues par Résonance Magnétique Nucléaire ;
- la figure 3, d'ores-et-déjà décrite, présente un premier exemple d'un spectre Z sous la forme d'un ensemble d'échantillons $Z(\Delta\omega)$ ordonnés en lien avec un volume élémentaire d'intérêt d'un organe ;
- la figure 4, d'ores-et-déjà décrite, présente le même exemple d'un spectre Z sous la forme d'un ensemble d'échantillons $Z(\Delta\omega)$ ordonnés que celui de la figure 3, superposé à un signal expérimental continu estimé après ajustement d'un modèle déterminé aux échantillons dudit spectre Z conformément à l'état de l'art ;
- la figure 5, d'ores-et-déjà décrite, présente le même exemple d'un spectre Z sous la forme d'un ensemble d'échantillons $Z(\Delta\omega)$ ordonnés que celui de la figure 3, superposé à un signal expérimental continu estimé après ajustement d'un modèle déterminé aux échantillons dudit spectre Z conformément à l'état de l'art, après correction et réglage de l'appareil d'imagerie médicale ;
- la figure 6A, d'ores-et-déjà décrite, présente une estimation d'un premier biomarqueur à partir d'échantillons d'un spectre Z conformément à l'état de l'art après correction et réglage de l'appareil d'imagerie ;
- la figure 6B, d'ores-et-déjà décrite, présente une estimation d'un deuxième biomarqueur à partir d'échantillons d'un spectre Z conformément à l'état de l'art après correction et réglage de l'appareil d'imagerie ;
- la figure 7, d'ores-et-déjà décrite, présente plusieurs exemples d'un spectre Z sous la forme d'un ensemble d'échantillons $Za(\Delta\omega)$, $Zb(\Delta\omega)$ ordonnés pour une pluralité de volumes élémentaires Va, Vb d'un cerveau humain, ainsi que des cartes paramétriques associées aux champs statique B0 et d'excitation B1 d'un appareil d'imagerie médicale ;
- la figure 8 décrit un premier mode de réalisation d'une étape d'un procédé de post-traitement d'un spectre WASAB1, selon l'invention, visant à détecter les échantillons dudit spectre décrivant des magnitudes d'un signal expérimental théorique dont la polarité est considérée positive aux décalages fréquentiels considérés ;
- la figure 9 décrit un deuxième mode de réalisation d'une étape d'un procédé de post-traitement d'un spectre WASAB1, selon l'invention, visant à détecter les échantillons dudit spectre décrivant des magnitudes d'un signal expérimental théorique dont la polarité est considérée connue aux décalages fréquentiels considérés ;
- la figure 10 illustre un exemple d'algorithme fonctionnel d'un procédé de post-traitement d'un spectre WASAB1, selon l'invention.

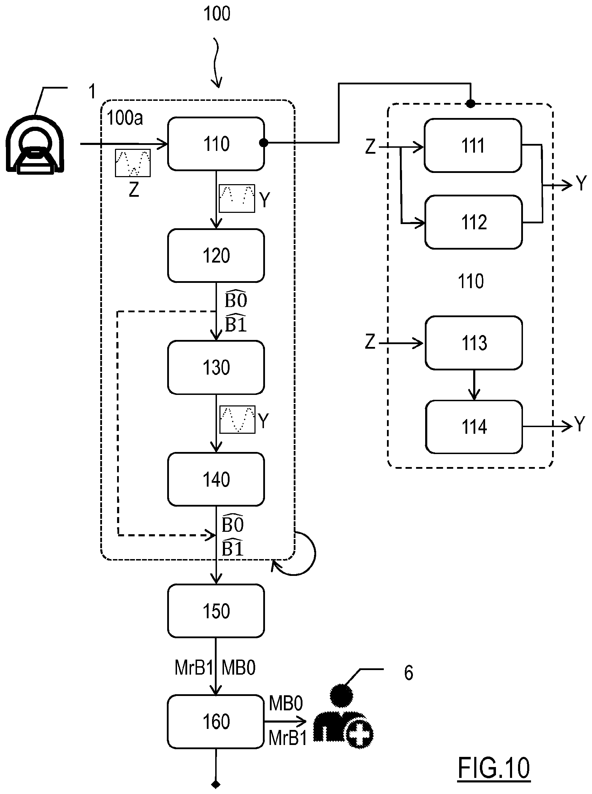

Décrivons à présent, en lien avec la figure 10, un exemple d'un procédé de post-traitement 100, selon l'invention, d'un premier ensemble Z d'échantillons $Z(\Delta\omega)$ d'un signal expérimental 10, 12, fruit d'une séquence d'acquisition WASAB1 par un appareil d'imagerie médicale par résonance magnétique 1, tel que celui décrit précédemment en liaison avec la figure 1 ou 2.

Un tel procédé 100 comporte un traitement 100a qui peut être mis en oeuvre itérativement pour une pluralité de volumes élémentaires d'un organe d'intérêt.

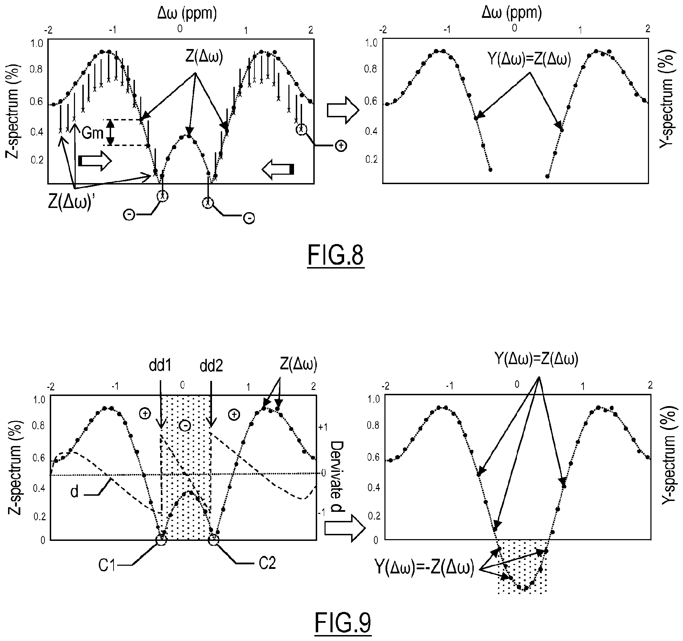

Un tel traitement 100a, mis en oeuvre pour un voxel ou volume élémentaire, comporte deux d'étapes 110 et 120, éventuellement complétées par deux étapes 130 et 140 comme nous le verrons ultérieurement en lien avec deux modes de réalisation avantageux. Un premier objectif de ce traitement 100a consiste à construire, en une étape 110, un deuxième ensemble d'échantillons Y à partir de l'ensemble des échantillons d'un premier spectre Z découlant une séquence WASAB1. Contrairement audit spectre Z pour lequel les échantillons $Z(\Delta\omega)$ peuvent décrire une amplitude d'un signal expérimental théorique 10, 12 dont la polarité est incertaine ou variable, le deuxième ensemble Y d'échantillons comporte des échantillons $Y(\Delta\omega)$ décrivant des amplitudes dudit signal expérimental théorique 10, 12 dont la polarité est connue. Nous étudierons successivement une telle construction du deuxième ensemble Y en liaison avec les figures 8 et 9 qui décrivent deux modes de réalisation distincts.

Selon un premier mode de réalisation illustré conjointement par les figures 8 et 10, le deuxième ensemble d'échantillons Y peut être constitué sous la forme d'un sous-ensemble du spectre Z pour lequel les échantillons $Y(\Delta\omega)$ sont respectivement égaux aux échantillons $Z(\Delta\omega)$ lorsque la polarité du signal expérimental théorique dont la magnitude est mesurée est certaine et positive. Pour cela, l'étape 110 comporte des sous-étapes 111 et 112, de sorte que certains échantillons du premier ensemble Z soient écartés et donc non reproduits dans le deuxième ensemble Y si la polarité du signal expérimental théorique dont la magnitude est mesurée, aux décalages fréquentiels considérés $\Delta\omega$, est incertaine, voire vraisemblablement négative.

En variante, en lien avec l'exemple de la figure 9, lorsque l'étape 110 comporte des sous-étapes 113 et 114, les échantillons $Y(\Delta\omega)$ du deuxième ensemble d'échantillons Y sont respectivement égaux aux échantillons $Z(\Delta\omega)$ du premier ensemble Z lorsque la polarité du signal expérimental théorique dont la magnitude est mesurée est certainement positive. Lesdits échantillons $Y(\Delta\omega)$ sont respectivement égaux aux $-Z(\Delta\omega)$ lorsque la polarité dudit signal expérimental théorique dont la magnitude est mesurée est certainement négative. Le deuxième ensemble Y d'échantillons est donc « polarisé » contrairement au spectre Z.

Quel que soit le mode de réalisation retenu, le modèle pour estimer les paramètres B0 et B1, lorsque celui-ci est ajusté en une étape 120 voire 140, au deuxième ensemble Y d'échantillons dont on connaît la polarité du signal expérimental théorique dont la magnitude est mesurée aux décalages fréquentiels considérés, n'intègre plus la notion de valeurs absolues, contrairement au modèle selon l'état de l'art. Grâce à l'apport de l'invention, ledit modèle est donc plus simple à ajuster et robuste. Nous verrons également que ce modèle peut être « ramené » de quatre paramètres à deux paramètres, décuplant d'un facteur cent les performances de mise en oeuvre d'un procédé de post-traitement 100 conforme à l'invention au regard de l'état de l'art.

Etudions en liaison avec les figures 8 et 10, un premier mode de réalisation de la première étape 110 d'un procédé de post-traitement 100 conforme à l'invention. Ladite étape 110 consiste à détecter les échantillons $Z(\Delta\omega)$ du premier ensemble Z pour lesquels la polarité des valeurs du signal expérimental théorique dont la magnitude est mesurée est certaine et positive. Ladite étape 110 consiste en outre à construire un deuxième ensemble Y d'échantillons $Y(\Delta\omega)$ tels que $Y(\Delta\omega)=Z(\Delta\omega)$ à partir des seuls échantillons $Z(\Delta\omega)$ précédemment détectés comme décrivant des mesures d'un signal expérimental théorique de polarité positive aux décalages fréquentiels $\Delta\omega$ considérés. La figure 8 illustre, dans la partie gauche, un spectre Z dont les échantillons $Z(\Delta\omega)$ sont représentés par des points et sont ordonnés selon des décalages fréquentiels croissants, en l'espèce depuis un décalage fréquentiel égal -2 ppm vers un décalage fréquentiel égal à +2 ppm. Ce premier ensemble d'échantillons Z ne comporte que des valeurs positives traduisant des mesures de la magnitude d'un signal expérimental théorique WASAB1 dont on ne connaît pas la polarité a priori. Sur la partie droite de ladite figure 8 est représenté, selon un même ordonnancement de décalages fréquentiels $\Delta\omega$, un deuxième ensemble Y d'échantillons construit à partir du premier ensemble Z. L'objectif de cette étape 110 est de construire l'ensemble Y de telle manière qu'il ne comporte que des échantillons $Y(\Delta\omega)$ identiques aux $Z(\Delta\omega)$ du premier ensemble Z, si et seulement si lesdits échantillons $Z(\Delta\omega)$ traduisent respectivement des mesures de la magnitude d'un signal expérimental théorique dont la polarité est certaine et positive aux décalages fréquentiels $\Delta\omega$ considérés. Les échantillons $Z(\Delta\omega)$ du premier ensemble Z, traduisant des mesures d'un signal expérimental théorique dont la polarité est incertaine, voire vraisemblablement négative, aux décalages fréquentiels considérés, sont écartés. Le deuxième ensemble d'échantillons Y est donc, comme l'indique la figure 8, un sous-ensemble du premier ensemble Z. Nous pouvons qualifier l'ensemble Y d'ensemble d'échantillons polarisés puisque la polarité du signal expérimental théorique dont la magnitude est mesurée est connue pour les décalages fréquentiels considérés.

Pour détecter les échantillons $Z(\Delta\omega)$ décrivant des mesures d'un signal expérimental théorique de polarité certainement positive aux décalages fréquentiels $\Delta\omega$ considérés, l'étape 110 comporte une première sous-étape 111 consistant, pour tout échantillon $Z(\Delta\omega)$, depuis le plus grand décalage fréquentiel négatif $\Delta\omega$, en valeur absolue, vers un tel décalage fréquentiel nul, à extrapoler la valeur dudit échantillon $Z(\Delta\omega)$ à partir de la ou des valeurs d'un ou plusieurs échantillons respectivement associés à des décalages fréquentiels négatifs supérieurs en valeurs absolues. A titre d'exemple préféré mais non limitatif, selon la figure 8, la valeur extrapolée $Z(\Delta\omega)'$, représentée par un 'x' sur la figure 8, d'un échantillon $Z(\Delta\omega)$, peut consister en une évaluation préalable du plus grand écart, référencé Gm sur la figure 8, entre les valeurs respectives de deux échantillons $Z(\Delta\omega)$ associés à des décalages fréquentiels successifs. Ladite étape 111 consiste alors à calculer la valeur extrapolée $Z(\Delta\omega)'$ en soustrayant ledit plus grand écart Gm à la valeur de l'échantillon associé au décalage fréquentiel supérieur en valeur absolue à celui associé à l'échantillon $Z(\Delta\omega)$ dont la valeur est extrapolée. Les barres verticales, connectées aux valeurs extrapolées et symbolisées par des 'x' sur la figure 8, illustrent ainsi cette opération d'extrapolation, réalisée de la gauche vers la droite, des échantillons $Z(\Delta\omega)$ depuis le décalage fréquentiel $\Delta\omega$ proche de -2 ppm vers le décalage fréquentiel proche de 0 ppm. La polarité du signal expérimental théorique dont la magnitude mesurée correspond aux échantillon $Z(\Delta\omega)$ est considérée comme certaine et positive tant que les valeurs extrapolée $Z(\Delta\omega)'$ demeurent positives ou tant que le décalage fréquentiel considéré $\Delta\omega$ n'est pas nul. Dès qu'une valeur extrapolée $Z(\Delta\omega)'$ est négative, cela signifie que le signal expérimental discret décrit par les échantillons du premier ensemble Z présente un point de rebroussement. L'étape 111 s'interrompt, les échantillons subséquents, c'est-à-dire associés aux décalages fréquentiels $\Delta\omega$ supérieurs, sont considérés comme décrivant des mesures d'un signal expérimental théorique dont la polarité est incertaine ou négative. Seuls les échantillons précédents sont détectés comme décrivant des mesures de la magnitude d'un signal expérimental théorique de polarité positive aux décalages fréquentiels considérés. Ces échantillons détectés sont ainsi reproduits dans le deuxième ensemble Y tel que $Y(\Delta\omega)=Z(\Delta\omega)$. Ainsi, dans l'exemple de la figure 8, à l'issue de la mise en oeuvre de la sous-étape 111, seuls les seize premiers échantillons sont considérés favorablement pour constituer l'ensemble Y. Le premier échantillon $Z(\Delta\omega)$, c'est-à-dire celui qui est associé au plus grand décalage fréquentiel en valeur absolue, est, par hypothèse, détecté favorablement pour initialiser l'étape 111.

L'étape 110 comporte en outre une sous-étape 112 décrivant un comportement miroir à celui de la sous-étape 111. Elle consiste à parcourir les échantillons $Z(\Delta\omega)$, de la droite vers la gauche sur la figure 8, c'est-à-dire depuis le décalage fréquentiel $\Delta\omega$ le plus grand vers un décalage fréquentiel nul, pour détecter les échantillons $Z(\Delta\omega)$ du premier ensemble Z traduisant des mesures de la magnitude d'un signal expérimental théorique dont la polarité est certaine et positive aux décalages fréquentiels considérés. Elle consiste en outre à enrichir le deuxième ensemble d'échantillons Y à partir de ces seuls échantillons détectés, tels que $Y(\Delta\omega)=Z(\Delta\omega)$ et à écarter les échantillons $Z(\Delta\omega)$ décrivant des mesures de la magnitude d'un signal expérimental théorique de polarité incertaine ou vraisemblablement négative pour les décalages fréquentiels considérés.

Pour cela, la sous-étape 112 consiste, pour tout échantillon $Z(\Delta\omega)$, depuis le plus grand décalage fréquentiel positif $\Delta\omega$ vers un tel décalage fréquentiel nul, à extrapoler la valeur dudit échantillon $Z(\Delta\omega)$ à partir de la ou des valeurs d'un ou plusieurs échantillons $Z(\Delta\omega)$ respectivement associés à des décalages fréquentiels $\Delta\omega$ positifs supérieurs. A titre d'exemple préféré mais non limitatif, selon la figure 8, la valeur extrapolée $Z(\Delta\omega)'$, représentée par un 'x' sur la figure 8, d'un échantillon $Z(\Delta\omega)$ peut consister en le calcul de la valeur extrapolée $Z(\Delta\omega)'$ d'un échantillon $Z(\Delta\omega)$ en soustrayant le plus grand écart Gm entre les valeurs respectives de deux échantillons associés à deux décalages fréquentiels consécutifs, écart Gm d'ores et déjà évoqué dans le cadre de la sous-étape 111, à la valeur de l'échantillon associé au décalage fréquentiel inférieur à celui associé à l'échantillon $Z(\Delta\omega)$ dont la valeur est extrapolée. Les barres verticales, connectées aux valeurs extrapolées et symbolisées par des 'x' sur la figure 8, illustrent ainsi cette opération d'extrapolation, réalisée de la droite vers la gauche, des échantillons $Z(\Delta\omega)$ depuis le décalage fréquentiel $\Delta\omega$ proche de +2 ppm vers le décalage fréquentiel $\Delta\omega$ proche de 0 ppm. La polarité du signal expérimental théorique dont la magnitude $Z(\Delta\omega)$ est mesurée pour les décalages fréquentiels $\Delta\omega$ est considéré comme certaine et positive tant que les valeurs extrapolées $Z(\Delta\omega)'$ demeurent positives et tant que le décalage fréquentiel considéré $\Delta\omega$ n'est pas nul. Dès qu'une valeur extrapolée $Z(\Delta\omega)'$ est négative, cela signifie que le signal discret, décrit par les échantillons du premier ensemble Z, présente un point de rebroussement. La sous-étape 112 s'interrompt, les échantillons subséquents, c'est-à-dire associés aux décalages fréquentiels $\Delta\omega$ inférieurs, sont considérés comme décrivant des mesures d'un signal expérimental théorique dont la polarité est incertaine ou négative. Seuls les échantillons précédents sont détectés comme décrivant des mesures d'un signal expérimental théorique dont la polarité est positive aux décalages fréquentiels considérés. Ces échantillons sont ainsi reproduits dans le deuxième ensemble Y tel que $Y(\Delta\omega)=Z(\Delta\omega)$. Ainsi, dans l'exemple de la figure 8, à l'issue de la mise en oeuvre de la sous-étape 112, seuls les quinze premiers échantillons sont considérés favorablement pour enrichir l'ensemble Y, l'échantillon $Z(\Delta\omega)$ associé au plus grand décalage fréquentiel étant, par hypothèse, détecté favorablement pour initialiser la sous-étape 112.

Les sous-étapes 111 et 112 ont été décrites au travers d'un exemple de mise en oeuvre préféré selon lequel l'élaboration de la valeur extrapolée $Z(\Delta\omega)'$, représentée par un 'x' sur la figure 8, d'un échantillon $Z(\Delta\omega)$ peut consister en une évaluation préalable du plus grand écart, référencé Gm sur la figure 8, entre les valeurs respectives de deux échantillons $Z(\Delta\omega)$ associés à des décalages fréquentiels successifs puis en la soustraction dudit plus grand écart Gm à la valeur de l'échantillon associé au décalage fréquentiel supérieur en valeur absolue à celui associé à l'échantillon $Z(\Delta\omega)$ dont la valeur est extrapolée. D'autres techniques d'extrapolation pourraient, en variante ou en complément, être mises en oeuvre. Nous pouvons de manière plus générale considérer que la valeur extrapolée $Z(\Delta\omega i)'$ d'un échantillon $Z(\Delta\omega i)$, c'est-à-dire le $i^{eme}$ échantillon associé au décalage fréquentiel $\Delta\omega i$ parmi les n échantillons disponibles, peut s'écrire selon la relation : $Z(\Delta\omega i)' = f(Z(\Delta\omega 1), Z(\Delta\omega 2, ..., Z(\Delta\omega n), P)$ où n est un entier positif, $f$ une fonction quelconque et P un paramètre quelconque, éventuellement pluriel. Ainsi, selon l'exemple précédent, la fonction $f$ vise à calculer l'écart Gm et à réaliser l'opération de soustraction et P=1 détermine le rang de l'échantillon précédent de celui dont la valeur $Z(\Delta\omega i)$ est extrapolée. En variante, selon un deuxième exemple de mise en oeuvre non limitatif, la fonction $f$ pourrait consister en le calcul de la valeur moyenne de valeurs de P échantillons subséquents à l'échantillon dont on cherche à extrapoler la valeur. D'autres combinaisons du couple $(f, P)$ pourraient en variante être exploitées sans sortir du cadre de la présente invention.

La figure 9 illustre un deuxième mode de réalisation de l'étape 110 d'un procédé de post-traitement 100 conforme à l'invention. Ladite étape 110 consiste à détecter les échantillons $Z(\Delta\omega)$ du premier ensemble Z pour lesquels la polarité des valeurs du signal expérimental théorique dont la magnitude est mesurée, est certaine. Ladite étape 110 consiste en outre à construire un deuxième ensemble Y d'échantillons $Y(\Delta\omega)$ tels que $Y(\Delta\omega)=Z(\Delta\omega)$ lorsque les échantillons $Z(\Delta\omega)$ décrivent des mesures d'un signal expérimental théorique de polarité certaine et positive et tels que $Y(\Delta\omega)=-Z(\Delta\omega)$ à partir des seuls échantillons $Z(\Delta\omega)$ décrivant des mesures d'un signal expérimental théorique de polarité certaine et négative. La figure 9, à l'instar de la figure 8 précédemment décrite, illustre dans la partie gauche un spectre Z dont les échantillons $Z(\Delta\omega)$ sont représentés par des points et sont ordonnés selon des décalages fréquentiels croissants, en l'espèce depuis -2 ppm vers +2 ppm. Ce premier ensemble d'échantillons Z comporte des valeurs positives traduisant des mesures de la magnitude d'un signal expérimental théorique WASAB1 dont on ne connaît pas la polarité a priori.

Sur la partie droite de ladite figure est représenté, selon un même ordonnancement des décalages fréquentiels Δω, un deuxième ensemble d'échantillons Y construit à partir du premier ensemble Z. L'objectif de cette étape 110 est de construire l'ensemble Y de telle manière qu'il comporte uniquement des échantillons Y(Δω) identiques à ceux Z(Δω) du premier ensemble Z si et seulement si lesdits échantillons Z(Δω) traduisent respectivement des mesures de la magnitude d'un signal expérimental théorique dont la polarité est certaine et positive aux décalages fréquentiels Δω considérés. Les échantillons Z(Δω) du premier ensemble Z, traduisant des mesures de la magnitude d'un signal expérimental théorique dont la polarité est certainement négative aux décalages fréquentiels considérés, sont tels que Y(Δω)=-Z(Δω). Le deuxième ensemble d'échantillons Y est donc, comme l'indique la figure 9, un ensemble d'échantillons que l'on peut qualifier de « polarisés » puisque la polarité du signal expérimental théorique est connue aux décalages fréquentiels considérés.

Pour détecter les échantillons Z(Δω) décrivant des mesures de la magnitude d'un signal expérimental théorique de polarité certainement positive ou négative pour les décalages fréquentiels Δω considérés, l'étape 110 comporte une première sous-étape 113 consistant, pour tout échantillon Z(Δω) depuis le plus grand décalage fréquentiel négatif Δω, en le calcul de la dérivée du signal discret Z résultant d'un ordonnancement des échantillons Z(Δω) selon des décalages fréquentiels Δω croissants. Cette dérivée apparaît sous la forme d'une courbe discontinue sur la figure 9. Compte tenu de la présence de points de rebroussement C1 et C2 dudit signal discret Z, la dérivée présente deux discontinuités franches dd1 et dd2 de son signe ou polarité. Il en serait tout autre en l'absence de tels points de rebroussements, c'est-à-dire si la polarité du signal expérimental théorique échantillonné était constante. L'étape 110 comporte une deuxième sous-étape 114 pour détecter de telles discontinuités de la polarité de ladite dérivée, la polarité de la mesure du signal expérimental théorique pour un ou plusieurs décalages fréquentiels successifs Δω étant inversée lors d'une discontinuité de la polarité de ladite dérivée. Ainsi, selon l'exemple illustré par la figure 9, l'étape 110 permet de considérer respectivement, en amont et en aval, desdits points de rebroussements C1 et C2, c'est-à-dire respectivement en amont et en aval desdites discontinuités dd1 et dd2, que la polarité du signal expérimental théorique est certaine et positive. Réciproquement, ladite polarité du signal expérimental théorique est considérée certaine et négative pour la plage, apparaissant grisée, des décalages fréquentiels comprise entre lesdits points de rebroussement C1 et C2. La forme du signal mesuré étant sensiblement en 'V', deux discontinuités du signe de la dérivée sont, au plus, attendues. C'est ainsi que les échantillons Z(Δω) détectés comme décrivant des mesures de la magnitude d'un signal expérimental théorique de polarité positive aux décalages fréquentiels considérés sont reproduits dans le deuxième ensemble Y tel que Y(Δω)=Z(Δω) et que les échantillons Z(Δω) détectés comme décrivant des mesures de la magnitude d'un signal expérimental théorique de polarité négative aux décalages fréquentiels considérés sont reproduits dans le deuxième ensemble Y tel que Y(Δω)=-Z(Δω). Ainsi, dans l'exemple de la figure 9, à l'issue de la mise en oeuvre de la sous-étape 114, l'ensemble des échantillons du premier ensemble Z est considéré favorablement pour constituer le deuxième ensemble Y d'échantillons polarisés, la polarité de la mesure du signal expérimental théorique étant considérée certaine pour l'ensemble des décalages fréquentiels Δω considérés.

Par la mise en oeuvre de l'étape 110, la polarité du signal expérimental théorique dont découle le deuxième ensemble Y d'échantillons Y(Δω) est connue à chaque décalage fréquentiel considéré. Contrairement à l'état de l'art pour lequel le modèle des intensités d'un spectre Z WASAB1, sur la base des équations de Bloch, s'exprime, sous une forme simplifiée, de telle sorte qu'un échantillon dudit spectre Z(Δω) est fonction, en valeur absolue, de quatre paramètres libres c, d, B1 et B0, l'exploitation du deuxième ensemble d'échantillons « polarisé » Y, en lieu et place du spectre Z permet d'évacuer le problème de complexité lié à la valeur absolue puisque la polarité du signal expérimental théorique est connue pour chaque échantillon Y(Δω). Ainsi, le modèle des intensités du spectre Y peut être écrit sous une forme simplifiée telle que Y(Δω)=c-d.$f$(B0, B1, Δω).

Les paramètres de ce modèle peuvent avantageusement s'obtenir en minimisant la somme de l'erreur quadratique :

$$\left[\hat{c}, \hat{d}, \widehat{B_0}, \widehat{B_1}\right] = \underset{c,d,B_0,B_1}{\operatorname{argmin}} \operatorname{SSE}(c, d, B_0, B_1)$$

pour laquelle :

$$\operatorname{SSE}(c, d, B_0, B_1) = \sum_{\Delta\omega} \left(Y(\Delta\omega) - \left(c - d \times f(B_0, B_1, \Delta\omega)\right)\right)^2$$

est la somme des erreurs quadratiques.

En supposant les paramètres B0 et B1 constants, le modèle devient linéaire en les paramètres c et d. Ces derniers peuvent être remplacés par leur estimation au minimum des moindres carrés qui s'exprime analytiquement en fonction de B0 et B1. En remplaçant ces paramètres c et d par leurs estimations en fonction de B0 et B1, le modèle n'a plus que deux paramètres explicites : B0 et B1. Les deux paramètres linéaires ont été rendus implicites. Selon l'invention, le modèle n'est plus un modèle à quatre paramètres mais à deux paramètres, ce qui rend l'estimation de B0 et B1 plus rapide de deux ordres de grandeurs, plus robuste et moins sensible aux minima locaux.

En effet, le modèle peut être écrit, pour T volumes élémentaires, sous une forme matricielle telle que Y = M(B0, B1)β, où Y=[Y($\Delta\omega$1), ...,Y($\Delta\omega$n)]^T décrit un vecteur contenant les n échantillons Y($\Delta\omega$), par volume élémentaire, pour les décalages fréquentiels $\Delta\omega$1 à $\Delta\omega$n, M est une matrice de taille 2n contenant les régresseurs ou variables du modèle soit :

$$M(B0, B1) = \begin{bmatrix} 1 & -f(B0, B1, \Delta\omega1) \\ \vdots & \vdots \\ 1 & -f(B0, B1, \Delta\omega n) \end{bmatrix}$$

En outre, β=[c,d]^T est un vecteur de taille deux, pour chaque volume élémentaire, contenant les paramètres linéaires c et d. La matrice M dépend explicitement des paramètres non linéaires du modèle, en l'espèce B0 et B1. Ainsi, la somme des erreurs quadratiques, précédemment exprimée, peut s'écrire à présent sous la forme :

$$SSE(B0, B1, \beta) = (Y - M\beta)^T(Y - M\beta)$$

Pour B0 et B1 constants, l'estimation optimale de β qui minimise la somme des erreurs quadratiques peut être calculée analytiquement telle que :

$$\hat{\beta} = (M^TM)^{-1}M^TY$$

Si l'on remplace cette estimation de β dans l'expression précédente on obtient :

$$SSE_{min}(B0, B1) = Y^T(1 - M(M^TM)^{-1}M^T)Y$$

Les paramètres c et d peuvent être estimés avec :

$$\hat{\beta} = \left(\widehat{M}^T\widehat{M}\right)^{-1}\widehat{M}^TY$$

où :

$$\widehat{M} = M(\widehat{B0}, \widehat{B1})$$

De cette manière, un procédé de post-traitement 100 selon l'invention comporte une étape 120 pour ajuster un modèle déterminé au deuxième ensemble Y d'échantillons polarisés, ensemble préalablement produit à l'étape 110, les deux paramètres dudit modèle déterminé décrivant respectivement les champs magnétiques statique B0 et d'excitation B1 de l'appareil d'imagerie médicale par résonance magnétique 1 tel que décrit à titre d'exemple par la figure 1. Ladite étape 120 produit ainsi une première estimation desdits paramètres B0 et B1 dudit modèle.

A titre d'exemple préféré, bien que ce mode de réalisation avantageux soit optionnel, l'invention prévoit qu'un procédé 100 comporte deux étapes 130 et 140 visant, conjointement à produire une deuxième estimation desdits paramètres B0 et B1, après enrichissement éventuel du deuxième ensemble Y d'échantillons polarisés.

En effet, puisque l'étape 120 a délivré une première estimation des paramètres du modèle, il est possible de déterminer avec précision les échantillons du spectre Z correspondant à des mesures de la magnitude du signal expérimental théorique alors que la polarité de celui est négative pour les décalages fréquentiels considérés. Cela peut être particulièrement avantageux d'enrichir le deuxième ensemble Y d'échantillons, notamment si ce dernier résulte d'une mise en oeuvre du premier exemple de réalisation de l'étape 110, c'est-à-dire lorsque ladite étape 110 comporte les sous-étapes 111 et 112. Dans ce cas, ledit deuxième ensemble d'échantillons Y est un sous-ensemble du premier ensemble Z dont les échantillons Y($\Delta\omega$) sont égaux respectivement aux échantillon Z($\Delta\omega$) lorsque la polarité du signal expérimental théorique est positive, les autres échantillons de Z étant écartés pour produire l'ensemble Y.

Dans ce cas, l'invention prévoit que le procédé 100 puisse comporter une étape optionnelle 130 pour déterminer la polarité des valeurs du signal expérimental théorique pour tout ou partie des échantillons $Z(\Delta\omega)$ à partir du modèle ainsi ajusté à l'étape 120 et construire de nouveau le deuxième ensemble Y d'échantillons tels que $Y(\Delta\omega)=Z(\Delta\omega)$ si la polarité la polarité du signal expérimental théorique est estimée positive et $Y(\Delta\omega)=-Z(\Delta\omega)$ si la polarité la polarité $(\Delta\omega)$ du signal expérimental théorique est estimée négative. Grâce à la mise en oeuvre successive des étapes 111, 112, 120 et 130, le deuxième ensemble d'échantillons Y est plus riche que celui obtenu après la seule mise en oeuvre de l'étape 110, à l'image de celui obtenu lorsque ladite étape 110 comporte les sous-étapes 113 et 114 précédemment décrites.

Un procédé 100 peut alors comporter une nouvelle itération de l'étape 120, représentée par une étape 140 sur la figure 10, subséquente à l'étape 130, pour ajuster le modèle à l'ensemble Y d'échantillons polarisés ainsi enrichi. L'étape 140 produit ainsi une nouvelle estimation des paramètres du modèle en utilisant davantage d'échantillons sans que soit pénalisée de manière significative la mise en oeuvre du procédé 100 compte tenu du gain découlant de l'exploitation d'un modèle simplifié au regard de celui selon l'état de l'art.

Les paramètres B0 et B1 étant notamment estimés de manière précise et rapide à l'issue d'une instance du traitement 100a pour un volume élémentaire d'intérêt, l'invention prévoit qu'un procédé 100 conforme à l'invention comporte autant d'itérations dudit traitement 100a pour produire des estimations notamment des paramètres B0 et B1 pour une pluralité de volumes d'intérêts.

Un procédé 100 peut alors comporter une étape 150 pour produire une image sous la forme d'une carte paramétrique, telle que la carte MBO ou MrB1 précédemment décrite en lien avec la figure 7, dont les pixels encodent respectivement les valeurs du paramètre B0 ou B1 estimés pour des volumes élémentaires d'intérêts. Cette carte ou ces cartes paramétriques peuvent en outre être affichées par une interface homme-machine de sortie adaptée, telle que l'interface 5 décrite en lien avec les figures 1 et 2, pour qu'un utilisateur 6 d'un système d'imagerie S puisse prendre connaissance des estimations desdits paramètres B0 ou B1, voire encore de tout autre biomarqueur que l'on peut produire à partir desdits paramètres. La mise en oeuvre d'un procédé de post-traitement d'un premier ensemble Z d'échantillons $Z(\Delta\omega)$ décrivant la magnitude d'un signal expérimental théorique fruit d'une séquence d'acquisition WASAB1 par un appareil d'imagerie médicale par résonance magnétique 1 devient parfaitement exploitable dans le domaine clinique, ouvrant ainsi la porte audit domaine clinique à la technique CEST notamment, pour quantifier un ou plusieurs biomarqueurs en lien avec une espèce chimique d'intérêt d'un organe humain ou animal pour, *in fine,* caractériser différentes lésions aux propriétés métaboliques altérées. L'invention ne saurait être réduite à cette seule exploitation. Elle trouve ainsi une place de choix dans toute application d'imagerie par résonance magnétique pour laquelle une correction d'inhomogénéités de champs statique B0 et d'excitation B1 est requise.

## Revendications

1. Procédé (100) de post-traitement d'un premier ensemble Z d'échantillons $Z(\Delta\omega)$ d'un signal expérimental (10, 12) fruit d'une séquence d'acquisition WASAB1 par un appareil d'imagerie médicale par résonance magnétique (1), en lien avec un volume élémentaire d'un organe, les valeurs respectives des échantillons $Z(\Delta\omega)$ dudit premier ensemble Z décrivant la magnitude d'un signal expérimental théorique selon des décalages fréquentiels $\Delta\omega$ par rapport à la fréquence de résonance de l'eau, ledit procédé étant mis en oeuvre par une unité de traitement (4) d'un système d'analyse d'imagerie, **caractérisé en ce qu'**il comporte :

   - une étape (110) pour détecter les échantillons $Z(\Delta\omega)$ du premier ensemble Z pour lesquels les polarités des valeurs du signal expérimental théorique (10, 12) sont considérées certaines et construire un deuxième ensemble Y d'échantillons $Y(\Delta\omega)$ tels que :

      a. $Y(\Delta\omega)=Z(\Delta\omega)$ si la polarité du signal expérimental théorique est considérée certaine et positive ;
      b. $Y(\Delta\omega)=-Z(\Delta\omega)$ si la polarité dudit signal expérimental théorique (10, 12) est considérée certaine et négative ;

   - une étape (120) pour ajuster un modèle déterminé au deuxième ensemble Y, les deux paramètres dudit modèle déterminé décrivant respectivement les champs magnétiques statique B0 et d'excitation B1 de l'appareil d'imagerie médicale par résonance magnétique (1) et produire une première estimation desdits paramètres B0 et B1 dudit modèle.

2. Procédé selon la revendication précédente comportant :

   - une étape (130) pour estimer la polarité des valeurs du signal expérimental théorique pour tout ou partie des échantillons Z(Δω) à partir du modèle ainsi ajusté et enrichir le deuxième ensemble d'échantillons Y comprenant un ensemble d'échantillons Y(Δω) tels que Y(Δω)=Z(Δω) si la polarité du signal expérimental théorique est estimée positive et Y(Δω)=-Z(Δω) si la polarité dudit signal expérimental théorique est estimée négative ;
- une étape (140) pour ajuster le modèle déterminé au deuxième ensemble Y d'échantillons et produire une deuxième estimation desdits paramètres B0 et B1.

3. Procédé selon l'une quelconque des revendications précédentes, pour lequel :

- l'étape (110), pour détecter les échantillons Z(Δω) du premier ensemble Z pour lesquels les polarités des valeurs du signal expérimental théorique sont considérées certaines, comporte :

• une première sous-étape (111), pour tout échantillon Z(Δω), depuis le plus grand décalage fréquentiel négatif (Δω) en valeur absolue vers un tel décalage fréquentiel nul, pour extrapoler la valeur dudit échantillon à partir de la ou des valeurs d'un ou plusieurs échantillons respectivement associés à différents décalages fréquentiels ;
• une deuxième sous-étape (112), pour tout échantillon Z(Δω), depuis le plus grand décalage fréquentiel (Δω) vers un tel décalage fréquentiel nul, pour extrapoler la valeur dudit échantillon à partir de la ou des valeurs d'un ou plusieurs échantillons respectivement associés à différents décalages fréquentiels ;

- la polarité du signal expérimental théorique pour tout décalage fréquentiel Δω est déterminée par le signe de valeur extrapolée Z(Δω)' de l'échantillon Z(Δω) pour ledit décalage fréquentiel,
- la polarité du signal expérimental théorique pour un décalage fréquentiel donné Δω est considérée certaine et positive tant qu'une valeur extrapolée Z(Δω)' d'un échantillon Z(Δω) demeure positive.

4. Procédé selon la revendication précédente, pour lequel l'extrapolation de la valeur d'un échantillon Z(Δω) consiste, pour les première (111) et deuxième (112) sous-étapes, en une évaluation préalable du plus grand écart (Gm) entre les valeurs respectives de deux échantillons Z(Δω) associés à des décalages fréquentiels successifs et en la soustraction dudit plus grand écart (Gm) à la valeur de l'échantillon associé au décalage fréquentiel supérieur en valeur absolue à celui associé à l'échantillon Z(Δω) dont la valeur est extrapolée.

5. Procédé selon l'une quelconque des revendications 1 à 2, pour lequel l'étape (110), pour détecter les échantillons Z(Δω) du premier ensemble Z pour lesquels les polarités des valeurs du signal expérimental théorique mesurées sont considérées certaines, comporte :

- une première sous-étape (113) pour calculer la dérivée d'un premier signal discret résultant d'un ordonnancement des échantillons dudit premier ensemble Z selon des décalages fréquentiels croissants ;
- une deuxième sous-étape (114) pour détecter tout discontinuité de la polarité de ladite dérivée ;

la polarité du signal expérimental théorique est considérée certaine pour l'ensemble des décalages fréquentiels Δω considérés, ladite polarité étant inversée lors de toute discontinuité détectée de la polarité de ladite dérivée.

6. Procédé selon l'une quelconque des revendications précédentes, pour lequel les étapes (100a, 110, 120, 130, 140) nécessaires à l'estimation des paramètres B0 et B1 en lien avec un volume élémentaire de l'organe sont itérées pour produire une pluralité d'estimations desdits paramètres B0 et B1 en lien respectivement avec une pluralité de volumes élémentaires dudit organe.

7. Procédé selon la revendication précédente, comportant une étape (160) pour produire une image sous la forme d'une carte paramétrique (MB0, MrB1) dont les pixels encodent respectivement les valeurs du paramètre B0 ou B1 estimé pour des volumes élémentaires d'intérêts.

8. Procédé selon la revendication précédente comportant une étape (160) pour provoquer un affichage de ladite image (MB0, MrB1) produite par une interface homme-machine de sortie (5) du système d'analyse d'imagerie.

9. Système d'analyse d'imagerie (S) comportant une unité de traitement (4), des moyens pour communiquer avec le monde extérieur et des moyens de mémorisation, **caractérisé en ce que** :

- les moyens pour communiquer sont agencés pour recevoir dudit monde extérieur des données expérimentales résultant d'une séquence d'acquisition WASAB1 de données réalisées par échantillonnage spectral d'un volume élémentaire d'un organe ;
- les moyens de mémorisation comportent des instructions de programme dont l'interprétation par ladite unité de traitement provoque la mise en oeuvre d'un procédé (100) selon l'une quelconque des revendications précédentes.

**10.** Produit programme d'ordinateur comportant une ou plusieurs instructions interprétables par l'unité de traitement (4) d'un système d'analyse d'imagerie (S) conforme à la revendication précédente, ledit programme d'ordinateur étant chargeable dans des moyens de mémorisation dudit système, **caractérisé en ce que** l'interprétation desdites instructions de programme par ladite unité de traitement provoque la mise en oeuvre d'un procédé (100) selon l'une quelconque des revendications 1 à 8.

**11.** Support de mémorisation lisible par un ordinateur comportant les instructions de programme d'un produit programme d'ordinateur selon la revendication précédente.

**Patentansprüche**

**1.** Verfahren (100) zur Nachbearbeitung eines ersten Satzes Z von Samples $Z(\Delta\omega)$ eines experimentellen Signals (10, 12), das aus einer WASAB1-Akquisitionssequenz durch ein medizinisches Magnetresonanz-Bildgebungsgerät (1) hervorgeht, in Verbindung mit einem Elementarvolumen eines Organs, wobei die jeweiligen Werte der Samples $Z(\Delta\omega)$ des genannten ersten Satzes Z die Größe eines theoretischen experimentellen Signals gemäß Frequenzverschiebungen $\Delta\omega$ in Bezug auf die Resonanzfrequenz des Wassers beschreiben, wobei das genannte Verfahren von einer Verarbeitungseinheit (4) eines Bildanalysesystems durchgeführt wird, **dadurch gekennzeichnet, dass** es Folgendes beinhaltet:

- einen Schritt (110) zum Erkennen der Samples $Z(\Delta\omega)$ des ersten Satzes Z, für die die Polaritäten der Werte des theoretischen experimentellen Signals (10, 12) als sicher angesehen werden, und Konstruieren eines zweiten Satzes Y von Samples $Y(\Delta\omega)$, wie z.B.:

    a. $Y(\Delta\omega)=Z(\Delta\omega)$, wenn die Polarität des theoretischen experimentellen Signals als sicher und positiv angesehen wird;
    b. $Y(\Delta\omega)=-Z(\Delta\omega)$, wenn die Polarität des genannten theoretischen experimentellen Signals (10, 12) als sicher und negativ angesehen wird;

- einen Schritt (120) zum Anpassen eines bestimmten Modells an den zweiten Satz Y, wobei die beiden Parameter des genannten bestimmten Modells jeweils das statische Magnetfeld B0 und das Anregungsmagnetfeld B1 des medizinischen Magnetresonanz-Bildgebungsgeräts (1) beschreiben, und zum Erzeugen einer ersten Schätzung der genannten Parameter B0 und B1 des genannten Modells.

**2.** Verfahren nach dem vorherigen Anspruch, das Folgendes beinhaltet:

- einen Schritt (130) zum Schätzen der Polarität der Werte des theoretischen experimentellen Signals für alle oder einige der Samples $Z(\Delta\omega)$ anhand des so angepassten Modells und Anreichern des zweiten Satzes von Samples Y mit einem Satz von Samples $Y(\Delta\omega)$, so dass $Y(\Delta\omega)=Z(\Delta\omega)$, wenn die Polarität des theoretischen experimentellen Signals positiv geschätzt wird, und $Y(\Delta\omega)=-Z(\Delta\omega)$, wenn die Polarität des genannten theoretischen experimentellen Signals negativ geschätzt wird;
- einen Schritt (140) zum Anpassen des bestimmten Modells an den zweiten Satz Y von Samples und zum Erzeugen einer zweiten Schätzung der genannten Parameter B0 und B1.

**3.** Verfahren nach einem der vorherigen Ansprüche, wobei:

- der Schritt (110) zum Erkennen der Samples $Z(\Delta\omega)$ des ersten Satzes Z, für die die Polaritäten der Werte des theoretischen experimentellen Signals als sicher angesehen werden, Folgendes beinhaltet:

    • einen ersten Unterschritt (111), für jedes Sample $Z(\Delta\omega)$, von der größten negativen Frequenzverschiebung $(\Delta\omega)$ als Absolutwert zu einer solchen Null-Frequenzverschiebung, um den Wert des genannten Samples auf der Basis des/der Werte(s) einer oder mehrerer Samples zu extrapolieren, die jeweils mit verschiedenen Frequenzverschiebungen assoziiert sind;

• einen zweiten Unterschritt (112), für jedes Samples Z($\Delta\omega$), von der größten Frequenzverschiebung ($\Delta\omega$) zu einer solchen Null-Frequenzverschiebung, um den Wert des genannten Samples auf der Basis des/der Werte(s) eines oder mehrerer Samples zu extrapolieren, die jeweils mit verschiedenen Frequenzverschiebungen assoziiert sind;

- die Polarität des theoretischen experimentellen Signals wird für jede Frequenzverschiebung $\Delta\omega$ durch das Vorzeichen des extrapolierten Wertes Z($\Delta\omega$)' des Samples Z($\Delta\omega$) für die genannte Frequenzverschiebung bestimmt,
- die Polarität des theoretischen experimentellen Signals wird für eine gegebene Frequenzverschiebung $\Delta\omega$ als sicher und positiv angesehen, solange ein extrapolierter Wert Z($\Delta\omega$)' eines Samples Z($\Delta\omega$) positiv bleibt.

4. Verfahren nach dem vorherigen Anspruch, wobei die Extrapolation des Wertes eines Samples Z($\Delta\omega$) für den ersten (111) und zweiten (112) Unterschritt in einer vorherigen Bewertung der größten Abweichung (Gm) zwischen den jeweiligen Werten von zwei mit aufeinanderfolgenden Frequenzverschiebungen assoziierten Samples Z($\Delta\omega$) und in der Subtraktion der genannten größten Abweichung (Gm) von dem Wert des mit der Frequenzverschiebung assoziierten Samples besteht, deren Absolutwert größer ist als der mit dem Sample Z($\Delta\omega$), dessen Wert extrapoliert wird, assoziierte Wert.

5. Verfahren nach einem der Ansprüche 1 bis 2, wobei der Schritt (110) zum Erkennen der Samples Z($\Delta\omega$) des ersten Satzes Z, für die die Polaritäten der gemessenen Werte des theoretischen experimentellen Signals als sicher angesehen werden, Folgendes beinhaltet:

- einen ersten Unterschritt (113) zum Berechnen der Ableitung eines ersten diskreten Signals, das sich aus einer Anordnung der Samples des genannten ersten Satzes Z gemäß zunehmenden Frequenzverschiebungen ergibt;
- einen zweiten Unterschritt (114) zum Erkennen jeglicher Diskontinuität der Polarität der genannten Ableitung;

die Polarität des theoretischen experimentellen Signals wird für die Gesamtheit der betrachteten Frequenzverschiebungen $\Delta\omega$ als sicher angesehen, wobei die genannte Polarität bei jeder erfassten Diskontinuität der Polarität der genannten Ableitung umgekehrt wird.

6. Verfahren nach einem der vorherigen Ansprüche, wobei die Schritte (100a, 110, 120, 130, 140), die zum Schätzen der Parameter B0 und B1 in Verbindung mit einem Elementarvolumen des Organs erforderlich sind, wiederholt werden, um mehrere Schätzungen der genannten Parameter B0 und B1 in Verbindung mit jeweils mehreren Elementarvolumen des genannten Organs zu erzeugen.

7. Verfahren nach dem vorherigen Anspruch, das einen Schritt (160) zum Erzeugen eines Bildes in Form einer parametrischen Karte (MB0, MrB1) beinhaltet, deren Pixel jeweils die Werte des geschätzten Parameters B0 oder B1 für Elementarvolumen von Interesse codieren.

8. Verfahren nach dem vorherigen Anspruch, das einen Schritt (160) zum Bewirken einer Anzeige des genannten Bildes (MB0, MrB1) beinhaltet, das von einer Mensch-Maschine-Ausgangsschnittstelle (5) des Bildanalysesystems erzeugt wird.

9. Bildanalysesystem (S), das eine Verarbeitungseinheit (4), Mittel zum Kommunizieren mit der Außenwelt und Speichermittel umfasst, **dadurch gekennzeichnet, dass**:

- die Mittel zum Kommunizieren zum Empfangen von experimentellen Daten von der genannten Außenwelt ausgelegt sind, die aus einer WASAB1-Akquisitionssequenz von Daten resultieren, die durch spektrale Abtastung eines Elementarvolumens eines Organs realisiert werden;
- die Speichermittel Programmbefehle enthalten, deren Interpretation durch die genannte Verarbeitungseinheit die Durchführung eines Verfahrens (100) nach einem der vorherigen Ansprüche bewirkt.

10. Computerprogrammprodukt, das einen oder mehrere Befehle umfasst, die von der Verarbeitungseinheit (4) eines Bildanalysesystems (S) nach dem vorherigen Anspruch interpretierbar sind, wobei das genannte Computerprogramm in Speichermittel des genannten Systems geladen werden kann, **dadurch gekennzeichnet, dass** die Interpretation der genannten Programmbefehle durch die genannte Verarbeitungseinheit die Durchführung eines Verfahrens (100) nach einem der Ansprüche 1 bis 8 bewirkt.

**11.** Computerlesbares Speichermedium, das die Programmbefehle eines Computerprogrammprodukts nach dem vorherigen Anspruch umfasst.

**Claims**

**1.** Method (100) for carrying out post-processing on a first set Z of samples $Z(\Delta\omega)$ of an experimental signal (10, 12) resulting from a WASAB1 acquisition sequence by a medical magnetic resonance imaging device (1), linked with an elementary volume of an organ, the respective values of the samples $Z(\Delta\omega)$ of said first set Z describing the magnitude of a theoretical experimental signal according to frequency offsets $\Delta\omega$ with respect to the resonant frequency of water, said method being implemented by a processing unit (4) of an imaging analysis system, **characterized in that** it includes:

- a step (110) of detecting the samples $Z(\Delta\omega)$ of the first set Z for which the polarities of the values of the theoretical experimental signal (10, 12) are considered to be certain and of constructing a second set Y of samples $Y(\Delta\omega)$ such that:

a. $Y(\Delta\omega)=Z(\Delta\omega)$ if the polarity of the theoretical experimental signal is considered to be certain and positive;
b. $Y(\Delta\omega)=-Z(\Delta\omega)$ if the polarity of said theoretical experimental signal (10, 12) is considered to be certain and negative;

- a step (120) of adjusting a determined model to the second set Y, the two parameters of said determined model describing respectively the static B0 and excitation B1 magnetic fields of the medical magnetic resonance imaging device (1), and of producing a first estimation of said parameters B0 and B1 of said model.

**2.** Method according to the preceding claim, including:

- a step (130) of estimating the polarity of the values of the theoretical experimental signal for all or some of the samples $Z(\Delta\omega)$ from the thus-adjusted model and of enhancing the second set Y of samples comprising a set of samples $Y(\Delta\omega)$ such that $Y(\Delta\omega)=Z(\Delta\omega)$ if the polarity of the theoretical experimental signal is estimated to be positive and $Y(\Delta\omega)=-Z(\Delta\omega)$ if the polarity of said theoretical experimental signal is estimated to be negative;
- a step (140) of adjusting the determined model to the second set Y of samples and of producing a second estimation of said parameters B0 and B1.

**3.** Method according to any one of the preceding claims, for which:

- step (110), of detecting the samples $Z(\Delta\omega)$ of the first set Z for which the polarities of the values of the theoretical experimental signal are considered to be certain, includes:

• a first sub-step (111), for any sample $Z(\Delta\omega)$, from the largest negative frequency offset $(\Delta\omega)$ in absolute values to such a frequency offset of zero, of extrapolating the value of said sample from the value or values of one or more samples respectively associated with different frequency offsets;
• a second sub-step (112), for any sample $Z(\Delta\omega)$, from the largest frequency offset $(\Delta\omega)$ to such a frequency offset of zero, of extrapolating the value of said sample from the value or values of one or more samples respectively associated with different frequency offsets;

- the polarity of the theoretical experimental signal for any frequency offset $\Delta\omega$ is determined by the extrapolated value sign $Z(\Delta\omega)'$ of the sample $Z(\Delta\omega)$ for said frequency offset,
- the polarity of the theoretical experimental signal for a given frequency offset $\Delta\omega$ is considered to be certain and positive as long as an extrapolated value $Z(\Delta\omega)'$ of a sample $Z(\Delta\omega)$ remains positive.

**4.** Method according to the preceding claim, for which the extrapolation of the value of a sample $Z(\Delta\omega)$ consists, for the first (111) and second (112) sub-steps, of a prior evaluation of the largest interval (Gm) between the respective values of two samples $Z(\Delta\omega)$ associated with successive frequency offsets and of the subtraction of said largest interval (Gm) from the value of the sample associated with the frequency offset that is greater in absolute values than the one associated with the sample $Z(\Delta\omega)$ the value of which is extrapolated.

**5.** Method according to any one of claims 1 to 2, for which step (110), of detecting the samples $Z(\Delta\omega)$ of the first set Z for which the polarities of the measured values of the theoretical experimental signal are considered to be certain, includes:

- a first sub-step (113) of calculating the derivative of a first discrete signal resulting from an ordering of the samples of said first set Z according to increasing frequency offsets;
- a second sub-step (114) of detecting any discontinuity of the polarity of said derivative;

the polarity of the theoretical experimental signal is considered to be certain for the set of the frequency offsets $\Delta\omega$ under consideration, said polarity being inverted when any discontinuity is detected in the polarity of said derivative.

6. Method according to any one of the preceding claims, for which the steps (100a, 110, 120, 130, 140) that are necessary for the estimation of the parameters B0 and B1 linked with an elementary volume of the organ are repeated in order to produce a plurality of estimations of said parameters B0 and B1 linked respectively with a plurality of elementary volumes of said organ.

7. Method according to the preceding claim, including a step (160) of producing an image in the form of a parametric map (MB0, MrB1) the pixels of which encode respectively the values of the parameter B0 or B1 estimated for elementary volumes of interest.

8. Method according to the preceding claim, including a step (160) of bringing about a display of said image (MB0, MrB1) produced by a human-machine output interface (5) of the imaging analysis system.

9. Imaging analysis system (S) including a processing unit (4), means for communicating with the outside world and storage means, **characterized in that**:

- the communication means are arranged to receive, from said outside world, experimental data resulting from a WASAB1 acquisition sequence of data produced by spectral sampling of an elementary volume of an organ;
- the storage means include program instructions the interpretation of which by said processing unit brings about the implementation of a method (100) according to any one of the preceding claims.

10. Computer program product including one or more instructions that can be interpreted by the processing unit (4) of an imaging analysis system (S) according to the preceding claim, said computer program being loadable onto storage means of said system, **characterized in that** the interpretation of said program instructions by said processing unit brings about the implementation of a method (100) according to any one of claims 1 to 8.

11. Computer-readable storage medium including the program instructions of a computer program product according to the preceding claim.

FIG.1

FIG.2

FIG.3

FIG.4

FIG.5

FIG.6A

FIG.6B

FIG.7

FIG.8

FIG.9

FIG.10